# EUROPÄISCHE PATENTSCHRIFT

(11) **EP 4 055 638 B1**
(45) Veröffentlichungstag und Bekanntmachung des Hinweises auf die Patenterteilung: **22.10.2025**
(21) Anmeldenummer: 20816390.7
(22) Anmeldetag: 05.11.2020
(51) Int. Cl.: H10K 30/81, H10K 30/88, H10K 30/00

(54) **OPTOELEKTRONISCHES BAUELEMENT, SOWIE VERFAHREN ZUR KONTAKTIERUNG EINES OPTOELEKTRONISCHEN BAUELEMENTS**
OPTOELECTRONIC COMPONENT AND METHOD FOR CONTACTING AN OPTOELECTRONIC COMPONENT
COMPOSANT OPTOÉLECTRONIQUE ET PROCÉDÉ DE CONTACT DE COMPOSANT OPTOÉLECTRONIQUE

(30) Priorität: 05.11.2019 DE 102019129832
(43) Veröffentlichungstag der Anmeldung: 14.09.2022
(73) Patentinhaber: Heliatek GmbH, 01139 Dresden (DE)
(72) Erfinder: WICHTENDAHL, Ralph, 01139 Dresden (DE)
(86) Internationale Anmeldenummer: PCT/DE2020/100950
(87) Internationale Veröffentlichungsnummer: WO 2021/089089

(56) Entgegenhaltungen:
- WO-A1-2013/001780
- US-A1- 2014 008 636
- US-A1- 2015 076 463
- US-A1- 2017 358 763
- US-A1- 2018 090 066

## Beschreibung

Die Erfindung betrifft ein optoelektronisches Bauelement, sowie ein Verfahren zur Kontaktierung eines solchen optoelektronischen Bauelements.

Die Optoelektronik setzt sich aus dem Gebiet der Optik und der Halbleiterelektronik zusammen. Sie umfasst insbesondere Systeme und Verfahren, die die Umwandlung von elektronisch erzeugte Energie in Lichtemission ermöglichen oder Lichtemissionen in Energie umwandeln. Optoelektronische Bauelemente, insbesondere organische optoelektronische Bauelemente, beispielsweise organische photovoltaische Elemente (OPVs) und organische Leuchtdioden (organic light emitting diode, OLEDs), erzeugen elektrische Energie oder wandeln elektrische Energie in Lichtemissionen um, welche zur Anwendung im weiteren Verlauf aus dem optoelektronischen Bauelement herausgeführt oder hineingeführt werden muss. Dazu werden Stromsammelschienen, sogenannte Busbars, eingesetzt. Stromsammelschienen stellen einen Punkt in einem optoelektronischen Bauelement dar, an dem die umgewandelte Energie gebündelt und in Form von elektrischen Strömen weitergeleitet wird.

Organische optoelektronische Bauelemente können beispielsweise durch Verdampfen der Materialien, durch Drucken von Polymeren oder durch Prozessieren aus Flüssigkeiten hergestellt werden. Der prinzipielle Aufbau organischer optoelektronischer Bauelemente ist in WO2004083958 oder WO2011138021 offengelegt.

Organische optoelektronische Bauelemente, insbesondere organische photovoltaische Zellen, zeigen eine stark verminderte Lebensdauer durch direkten Kontakt mit Luft, Sauerstoff, Wasser und/oder Feuchtigkeit, und müssen daher durch eine Verkapselung geschützt werden. Optoelektronische Bauelemente werden deshalb in der Regel zum Schutz vor äußeren Einflüssen mit einer Schutzschicht versehen oder verkapselt, insbesondere um diese mechanisch und gegen Umwelteinflüsse, beispielsweise Feuchtigkeit oder Diffusion von Sauerstoff, zu schützen. Die Verkapselung kann durch Barrierefolien oder durch eine Direktverkapselung ausgeführt werden.

Organische optoelektronische Bauelemente werden mittels Laserprozessen strukturiert. Diese Verfahren werden insbesondere zur Verschaltung einzelner photovoltaischer Zellen auf einem optoelektronischen Bauelement, als auch zur elektrischen Trennung von photovoltaischen Zellen eingesetzt. Durch die Laserstrukturierung, insbesondere einer Laserstrukturierung der Elektroden, können Aufwürfe entstehen, sogenannte laser scribes, die die Höhe der Schichten der flachen Topologie eines Schichtsystems eines organischen photovoltaischen Elements um ein Vielfaches übersteigen. Dadurch können einerseits weitere Schichten, insbesondere eine Barriereschicht, nur schwer aufgetragen werden, andererseits kann bei einer anschließenden Verkapselung eine bereits aufgetragene Schicht beschädigt werden. Bekannte Prozesse zur Integration einer Dünnschichtverkapselung sind sehr empfindlich hinsichtlich der Topologie einzelner Schichten des Schichtsystems und führen zu Höhenunterschieden innerhalb einer Schicht des Schichtsystems. Die meisten Dünnschichtverkapselungen weisen deshalb eine Planarisierungsschicht auf, bevor eine Barriereschicht aufgebracht wird.

Bei der Integration der Dünnschichtverkapselung in photovoltaische Elemente, insbesondere Solarzellen, muss eine Kontaktierung mittels Stromsammelschienen, sogenannten Busbars, durchgeführt werden. Die Kontaktierung muss auch innerhalb des Bereichs erfolgen, in dem die Dünnschichtverkapselung, also eine Barriereschicht, liegt. Nachteilig aus dem Stand der Technik ist jedoch insbesondere, dass eine solche Kontaktierung sehr aufwendig und kostenintensiv ist.

Dokumente US 2018/090066 A1, US 2014/008636 A1, WO 2013/001780 A1, US 2017/358763 A1 und US 2015/076463 A1 offenbaren ein optoelektronisches Bauelement mit einer Planarisierungsschicht, die mit elektrisch leitenden Partikeln versehen sind.

Aufgabe der vorliegenden Erfindung ist es ein optoelektronisches Bauelement und ein Verfahren zum Herstellen eines solchen optoelektronischen Bauelements bereitzustellen, wobei die im Stand der Technik beschriebenen Nachteile nicht auftreten. Das der vorliegenden Erfindung zugrundeliegende technische Problem besteht insbesondere darin, einerseits durch Laserstrukturierung der einzelnen Schichten eines optoelektronischen Bauelements entstandene Aufwürfe zu planarisieren, so dass eine Barriereschicht auftragbar ist, um eine Versiegelung bzw. Abdichtung mittels einer dünnen Schicht zu ermöglichen, andererseits eine elektrisch leitende Kontaktierung einer Schicht des optoelektronischen Bauelements, insbesondere einer Elektrodenschicht, mit einer über der Barriereschicht angeordneten Schicht, insbesondere einer Stromsammelschiene, bereitzustellen. Das Verfahren soll insbesondere in ein Rolle-zu-Rolle-Verfahren integrierbar sein.

Die Aufgabe wird durch die Gegenstände der unabhängigen Ansprüche gelöst. Vorteilhafte Ausgestaltungen ergeben sich aus den Unteransprüchen. Die Aufgabe wird insbesondere gelöst, indem ein optoelektronisches Bauelement, insbesondere ein photovoltaisches Element, bereitgestellt wird, aufweisend eine Grundelektrode, eine Deckelektrode, und ein Schichtsystem mit mindestens einer photoaktiven Schicht, wobei das Schichtsystem zwischen der Grundelektrode und der Deckelektrode angeordnet ist, eine auf der von dem Schichtsystem abgewandten Seite der Grundelektrode und/oder der Deckelektrode angeordnete Planarisierungsschicht, mindestens eine auf der Planarisierungsschicht angeordnete Barriereschicht, wobei die Barriereschicht nicht elektrisch leitfähig ist und über das gesamte Schichtsystem des optoelektronischen Bauelements ausgebildet ist, und mindestens eine Stromsammelschiene, wobei die mindestens eine Stromsammelschiene auf der mindestens einen Barriereschicht angeordnet ist. Die Planarisierungsschicht weist elektrisch leitfähige Partikel auf, wobei die elektrisch leitfähigen Partikel in die Planarisierungsschicht eingebracht sind, und wobei die elektrisch leitfähigen Partikel die Planarisierungsschicht durch die mindestens eine Barriereschicht hindurch elektrisch leitend überbrücken, so dass die Grundelektrode und/oder die Deckelektrode mit der mindestens einen Stromsammelschiene elektrisch leitend kontaktiert sind. Das optoelektronische Bauelement ist insbesondere ein photovoltaisches Element.

In einer bevorzugten Ausführungsform der Erfindung sind die Grundelektrode, das Schichtsystem und/oder die Deckelektrode laserstrukturiert. In einer bevorzugten Ausführungsform der Erfindung ist das Schichtsystem mittels einer Laserstrukturierung mit der Grundelektrode und/oder der Deckelektrode elektrisch leitend verbunden. In einer bevorzugten Ausführungsform der Erfindung bildet die Grundelektrode eine Kathode und die Deckelektrode eine Anode, wobei die Grundelektrode und die Deckelektrode das Schichtsystem elektrisch leitend kontaktieren.

In einer bevorzugten Ausführungsform der Erfindung sind die elektrisch leitfähigen Partikel in die Planarisierungsschicht eingebracht, wobei die elektrisch leitfähigen Partikel die Planarisierungsschicht durch die mindestens eine Barriereschicht hindurch elektrisch leitend überbrücken. Dadurch sind insbesondere die Deckelektrode und die Stromsammelschiene des optoelektronischen Bauelements mittels der die elektrisch leitfähigen Partikel aufweisenden Planarisierungsschicht miteinander elektrisch leitend verbunden.

Unter einer Planarisierungsschicht wird insbesondere eine Schicht zum Ebnen von Unebenheiten, insbesondere zum Reduzieren einer Rauheit, mindestens einer anderen Schicht des optoelektronischen Bauelements verstanden, insbesondere eine Schicht einer Grundelektrode und/oder eine Schicht einer Deckelektrode.

Unter einem optoelektronischen Bauelement wird insbesondere eine elektromagnetische Strahlung emittierendes Bauelement oder ein elektromagnetische Strahlung absorbierendes Bauelement verstanden. Ein elektromagnetische Strahlung absorbierendes Bauelement ist bevorzugt ein organisches photovoltaisches Element (OPV) oder eine organische Photozelle. Ein elektromagnetische Strahlung emittierendes Bauelement ist bevorzugt eine OLED (organic light emitting diode) oder ein Transistor.

Unter einem photovoltaischen Element wird insbesondere eine photovoltaische Zelle verstanden, insbesondere eine Solarzelle. Das photovoltaische Element ist bevorzugt aus mehreren photovoltaischen Zellen aufgebaut, die in Reihe oder parallel verschaltet sein können. Die mehreren photovoltaischen Zellen können auf unterschiedliche Weise in dem photovoltaischen Element angeordnet und/oder verschaltet sein.

Unter einer Stromsammelschiene, einem sogenannten Busbar, wird insbesondere eine Anordnung verstanden, die zur elektrischen Kontaktierung als zentraler Verteiler von elektrischer Energie an ankommende und abgehende Leitungen elektrisch leitend verbunden ist, bevorzugt mit mindestens einer Grundelektrode und/oder mindestens einer Deckelektrode. Die Stromsammelschiene ist insbesondere planar als Band, Streifen, Platte oder als Metallschicht ausgebildet.

In einer bevorzugten Ausführungsform der Erfindung weist die mindestens eine Stromsammelschiene eine Schichtdicke von 10 µm bis 500 µm auf, bevorzugt von 100 µm bis 500 µm, bevorzugt von 10 µm bis 200 µm, bevorzugt von 10 µm bis 100 µm, bevorzugt von 10 µm bis 50 µm, bevorzugt von 20 µm bis 80 µm, bevorzugt von 20 µm bis 40 µm, oder bevorzugt von 30 µm bis 50 µm.

In einer bevorzugten Ausführungsform der Erfindung ist die mindestens eine Stromsammelschiene direkt oder mittels einer zwischen der Barriereschicht und der mindestens einen Stromsammelschiene angeordneten Klebeschicht auf der Barriereschicht angeordnet. In einer bevorzugten Ausführungsform der Erfindung weist die Stromsammelschiene eine Klebeschicht auf, wobei die Stromsammelschiene mittels der Klebeschicht an der mindestens einen Barriereschicht angeordnet ist. In einer bevorzugten Ausführungsform der Erfindung weist die Stromsammelschiene und/oder die Stromsammelschiene mit einer daran angeordneten Klebeschicht eine Schichtdicke von 10 µm bis 100 µm auf, bevorzugt von 10 µm bis 80 µm, bevorzugt von 20 µm bis 80 µm, bevorzugt von 30 µm bis 100 µm, bevorzugt von 30 µm bis 80 µm, oder bevorzugt von 30 µm bis 60 µm.

In einer bevorzugten Ausführungsform der Erfindung sind die Grundelektrode und/oder die Deckelektrode mittels der elektrisch leitfähigen Partikel durch die mindestens eine Barriereschicht hindurch elektrisch leitend mit der Klebeschicht und/oder der mindestens einen Stromsammelschiene verbunden.

Ein möglicher Aufbau des Schichtsystems eines photovoltaischen Elements ist in WO2004083958A2, WO2011013219A1, WO2011138021A2, und WO2011161108A1 beschrieben. In den hier genannten Anmeldungen werden vorzugsweise Schichtsysteme verwendet, bei denen die photoaktiven Schichten Absorbermaterialien umfassen, die verdampfbar sind und durch Verdampfung (engl. vapor deposition) aufgebracht werden bzw. aufgebracht sind. Dafür werden Materialien die zur Gruppe der "kleinen Moleküle" gehören, verwendet, die unter anderem in WO2006092134A1, WO2010133208A1, WO2014206860A1, WO2014128278A1, WO2017114937A1, und WO2017114938A1 beschrieben sind. Die photoaktiven Schichten bilden Akzeptor-Donor-Systeme, und können aus mehreren Einzelschichten, oder aus Mischschichten, als planar-heterojunction, und bevorzugt als bulkheterojunction. Bevorzugt sind Schichtsysteme, die vollständig durch Verdampfung aufgetragen sind.

Das Schichtsystem kann als Single-, Tandem- oder Multizelle ausgeführt sein, die Bezeichnung bestimmt sich durch die Anzahl der Subzellen, wobei jede Subzelle mindestens eine photoaktive Schicht enthält, die bevorzugt durch Transportschichten, und optionalen Rekombinationsschichten, getrennt sind und selbst aus mehreren Schichten bestehen können. Die p- oder n-Schichtsysteme, auch nur p- oder n-Schicht bezeichnet, können aus mehreren Schichten bestehen, wobei mindestens eine der Schichten des p- oder n- Schichtsystems p-dotiert oder n-dotiert ist, vorzugsweise als p- oder n-dotierte widegap-Schicht. Das i-Schichtsystem, auch als i-Schicht bezeichnet, ist eine undotierte oder gegenüber den p- bzw. n-Schichten in der Subzelle geringer, also schwächer dotiert, und als photoaktive Schicht ausgeführt. Jede dieser n-, p-, i-Schichten kann aus weiteren Schichten bestehen, wobei die n- bzw. p-Schicht aus mindestens einer dotierten n- bzw. p-Schicht besteht, die durch ihre Dotierung zu einer Erhöhung der Ladungsträger beiträgt. Das bedeutet, dass das Schichtsystem des optoelektronischen Bauelements aus einer sinnvollen Kombination von p-, n-, und i-Schichtsystemen besteht, d.h. dass jede Subzelle ein i-Schichtsystem und mindestens ein p- oder n-Schichtsystem umfasst.

Einzelne Schichten des optoelektronischen Bauelements werden zum Herstellen des optoelektronischen Bauelements auf einem Substrat abgeschieden. Hierbei ist es für ein defektfreies Abscheiden und/oder defektfreies Verbinden einer folgenden Schicht notwendig, eine Oberfläche darunterliegender Schichten zu planarisieren, insbesondere eine Unebenheit der Oberfläche zu verringern.

In einer Bevorzugten Ausführungsform der Erfindung ist die Grundelektrode auf einem Substrat angeordnet, insbesondere einer Folie. In einer bevorzugten Ausführungsform der Erfindung weist das optoelektronische Bauelement ein Substrat auf, wobei das Substrat insbesondere ein Träger ist. In einer bevorzugten Ausführungsform ist das Substrat eine Folie, bevorzugt eine Folie ausgebildet aus einem Kunststoff, insbesondere ist die Folie zumindest teilweise transparent.

Unter einer Barriereschicht wird insbesondere eine Schutzschicht verstanden, die eine Barriere gegenüber chemischen Verunreinigungen, Feuchtigkeit und/oder Sauerstoff bildet. Die Barriereschicht ist insbesondere eine Schutzschicht zum Verhindern der Durchlässigkeit von äußeren Einflüssen, insbesondere von Luftsauerstoff und/oder Feuchtigkeit, eine Schutzschicht zur Erhöhung der mechanischen Widerstandsfähigkeit, insbesondere Kratzfestigkeit, und/oder eine Filterschicht, bevorzugt eine Schicht mit einem UV-Filter.

In einer bevorzugten Ausführungsform weist das optoelektronische Bauelement mindestens eine Zelle mit mindestens einer photoaktiven Schicht auf, insbesondere eine CIS-, CIGS-, GaAs-, oder Si-Zelle, eine Perovskit-Zelle oder ein organisches photovoltaisches Element (OPV), eine sogenannte organische Solarzelle. Unter einem organische photovoltaische Element wird insbesondere ein photovoltaisches Element mit mindestens einer organischen photoaktiven Schicht verstanden, insbesondere ein polymeres organisches photovoltaisches Element oder ein organisches photovoltaisches Element auf Basis kleiner Moleküle. Während Polymere sich dadurch auszeichnen, dass diese nicht verdampfbar sind und daher nur aus Lösungen aufgebracht werden können, sind kleine Moleküle meist verdampfbar und können entweder wie Polymere als Lösung aufgebracht werden, aber auch mittels Verdampfungstechnik, insbesondere durch Verdampfen aus dem Vakuum.

In einer bevorzugten Ausführungsform der Erfindung umfasst die mindestens eine photoaktive Schicht des Schichtsystems kleine Moleküle, welche im Vakuum verdampfbar sind. In einer bevorzugten Ausführungsform der Erfindung ist zumindest eine photoaktive Schicht des Schichtsystems im Vakuum aufgedampft.

Unter kleinen Molekülen werden insbesondere nicht-polymere organische Moleküle mit monodispersen molaren Massen zwischen 100 und 2000 g/mol verstanden, die unter Normaldruck (Luftdruck der uns umgebenden Atmosphäre) und bei Raumtemperatur in fester Phase vorliegen. Insbesondere sind die kleinen Moleküle photoaktiv, wobei unter photoaktiv verstanden wird, dass die Moleküle unter Lichteintrag ihren Ladungszustand und/oder ihren Polarisierungszustand ändern. Vorteile dieser Absorbermaterialien auf der Basis kleiner Moleküle sind eine Verdampfbarkeit im Vakuum.

In einer bevorzugten Ausführungsform der Erfindung ist die mindestens eine Stromsammelschiene als eine Metallschicht aus mindestens einem Metall oder einer Legierung davon ausgebildet, bevorzugt aus Aluminium oder einer Legierung davon.

In einer bevorzugten Ausführungsform der Erfindung ist die Planarisierungsschicht nicht elektrisch leitfähig.

In einer bevorzugten Ausführungsform der Erfindung ist die Deckelektrode aus Silber oder eine Silberlegierung, Aluminium oder eine Aluminiumlegierung, Gold oder eine Goldlegierung, oder einer Kombination dieser Materialien gebildet, bevorzugt als Silberlegierung aus Ag:Mg oder Ag:Ca.

In einer bevorzugten Ausführungsform der Erfindung weist die Grundelektrode ITO (Indiumzinnoxid) auf.

In einer bevorzugten Ausführungsform der Erfindung weist das photovoltaische Element ein Schichtsystem mit mindestens zwei photoaktiven Schichten auf, wobei das photovoltaische Element eine Tandem-Zelle ist, bevorzugt mit mindestens drei photoaktiven Schichten, wobei das photovoltaische Element eine Triple-Zelle ist.

In einer bevorzugten Ausführungsform der Erfindung weist das Schichtsystem zusätzlich mindestens eine Ladungsträgertransportschicht auf, wobei die mindestens eine Ladungsträgertransportschicht zwischen der Grundelektrode oder der Deckelektrode und einer photoaktiven Schicht angeordnet ist, bevorzugt weist das Schichtsystem mindestens eine erste Ladungsträgertransportschicht und eine zweite Ladungsträgertransportschicht auf, wobei die erste Ladungsträgertransportschicht zwischen der Grundelektrode und der mindestens einen photoaktiven Schicht angeordnet ist, und wobei die zweite Ladungsträgertransportschicht zwischen der mindestens einen photoaktiven Schicht und der Deckelektrode angeordnet ist.

In einer bevorzugten Ausführungsform der Erfindung ist die Planarisierungsschicht über das gesamte Schichtsystem des optoelektronischen Bauelements ausgebildet.

Das erfindungsgemäße optoelektronische Bauelement weist Vorteile im Vergleich zum Stand der Technik auf. Vorteilhafterweise wird eine geschlossene planare Topologie einer Elektrodenschicht erhalten. Vorteilhafterweise wird eine einfache und sichere elektrisch leitende Kontaktierung des optoelektronischen Bauelements, insbesondere innerhalb des optoelektronischen Bauelements zwischen einer Elektrode und einer Stromsammelschiene ermöglicht. Vorteilhafterweisen wird die Planarisierungsschicht durch die elektrisch leitfähigen Partikel elektrisch leitend überbrückt. Vorteilhafterweise wird eine Beschädigung des Schichtsystems und/oder der Elektroden bei der Kontaktierung vermieden. Vorteilhafterweise werden keine oder kaum Verluste der elektrischen Leitfähigkeit bei einer solchen elektrisch leitenden Kontaktierung beobachtet. Vorteilhafterweise wird die Kontaktierung auf eine kostengünstige und einfache Art und Weise ermöglicht. Vorteilhafterweise wird mittels einer derartigen elektrisch leitenden Kontaktierung die Lebensdauer optoelektronischer Bauelemente erhöht. Vorteilhafterweise ermöglicht die Planarisierungsschicht mit den elektrisch leitfähigen Partikeln eine Reduzierung der Unebenheit der darunterliegenden Schicht, insbesondere der Oberfläche der darunterliegenden Schicht, und gleichzeitig eine elektrisch leitende Kontaktierung. Vorteilhafterweise sind die elektrisch leitfähigen Partikel besonders leicht in die Planarisierungsschicht integrierbar. Vorteilhafterweise ist das Verfahren in einem Rolle-zu-Rolle Verfahren integrierbar.

Gemäß einer Weiterbildung der Erfindung ist vorgesehen, dass die Planarisierungsschicht eine Schichtdicke von 5 µm bis 100 µm aufweist, bevorzugt von 10 µm bis 50 µm, und/oder die mindestens eine Barriereschicht eine Schichtdicke von 100 nm bis 2000 nm aufweist, bevorzugt von 100 nm bis 1000 nm, bevorzugt von 150 nm bis 1000 nm, bevorzugt von 200 nm bis 800 nm, oder bevorzugt von 300 nm bis 600 nm.

In einer bevorzugten Ausführungsform weist die Planarisierungsschicht eine Schichtdicke von weniger als 200 µm auf, bevorzugt von weniger als 100 µm, bevorzugt von weniger als 70 µm, bevorzugt von weniger als 50 µm, bevorzugt von weniger als 30 µm, bevorzugt von 10 µm bis 200 µm, bevorzugt von 10 µm bis 100 µm, bevorzugt von 10 µm bis 70 µm, bevorzugt von 10 µm bis 50 µm, oder bevorzugt von 10 µm bis 30 µm.

In einer weiteren bevorzugten Ausführungsform weist die Barriereschicht eine Schichtdicke von weniger als 10 µm auf, bevorzugt von weniger als 5 µm, bevorzugt von weniger als 3 µm, oder bevorzugt von weniger als 1 µm.

Gemäß einer Weiterbildung der Erfindung ist vorgesehen, dass die elektrisch leitfähigen Partikel einen mittleren Durchmesser von 1 µm bis 100 µm aufweisen, bevorzugt von 1 µm bis 50 µm, und/oder der mittlere Durchmesser der elektrisch leitfähigen Partikel größer ist als die Schichtdicke der Planarisierungsschicht, bevorzugt bis zu 100% größer als die Schichtdicke der Planarisierungsschicht, oder bevorzugt bis zu 10% größer.

Im Zusammenhang mit der vorliegenden Erfindung wird unter einem Durchmesser insbesondere ein Äquivalentdurchmesser verstanden, bevorzugt ein geometrischer Äquivalentdurchmesser, wobei insbesondere auch der Durchmesser von unregelmäßig geformten Partikeln verstanden wird. Der geometrische Äquivalentdurchmesser wird durch Bestimmung des Durchmessers einer Kugel oder eines Kreises mit gleicher geometrischer Eigenschaft erhalten.

In einer bevorzugten Ausführungsform der Erfindung weisen die elektrisch leitfähigen Partikel einen mittleren Durchmesser von 1 µm bis 100 µm auf, bevorzugt von 1 µm bis 70 µm, bevorzugt von 1 µm bis 50 µm, oder bevorzugt von 1 µm bis 30 µm. In einer bevorzugten Ausführungsform der Erfindung weisen die elektrisch leitfähigen Partikel einen mittleren Durchmesser auf, der größer ist als die Schichtdicke der Planarisierungsschicht. In einer bevorzugten Ausführungsform der Erfindung weisen die elektrisch leitfähigen Partikel eine bestimmte Größenverteilung auf, wobei bevorzugt die bestimmte Größenverteilung der elektrisch leitfähigen Partikel eine möglichst geringe Standardabweichung aufweist.

In einer bevorzugten Ausführungsform der Erfindung ist ein mittlerer Durchmesser der elektrisch leitfähigen Partikel größer als die Schichtdicke der Planarisierungsschicht, bevorzugt bis zu 200% größer als die Schichtdicke der Planarisierungsschicht, bevorzugt bis zu 150%, bevorzugt bis zu 100%, bevorzugt bis zu 80%, bevorzugt bis zu 60%, bevorzugt bis zu 50%, bevorzugt bis zu 40%, bevorzugt bis zu 30%, bevorzugt bis zu 20%, bevorzugt bis zu 10%, bevorzugt bis zu 5%, bevorzugt bis zu 2%, oder bevorzugt bis zu 1%, oder bevorzugt mindestens 1% größer als die Schichtdicke der Planarisierungsschicht, bevorzugt mindestens 2%, bevorzugt mindestens 5%, bevorzugt mindestens 10%, bevorzugt mindestens 20%, bevorzugt mindestens 30%, oder bevorzugt mindestens 50%.

In einer alternativ bevorzugten Ausführungsform der Erfindung ist der mittlere Durchmesser der elektrisch leitfähigen Partikel kleiner als die Schichtdicke der Planarisierungsschicht, wobei sich eine Vielzahl der elektrisch leitfähigen Partikel innerhalb der Planarisierungsschicht elektrisch leitend berührt, so dass die elektrische leitende Kontaktierung durch die Planarisierungsschicht hindurch gewährleistet ist.

Gemäß einer Weiterbildung der Erfindung ist vorgesehen, dass die Form der elektrisch leitfähigen Partikel kugelförmig, eckig, nadelförmig, und/oder kristallförmig ausgebildet ist, bevorzugt ist die Form der elektrisch leitfähigen Partikel untereinander unterschiedlich ausgebildet, und/oder die elektrisch leitfähigen Partikel regelmäßig oder unregelmäßig geformt sind, bevorzugt als Splitter, Kristalle oder Granulat ausgebildet sind.

In einer bevorzugten Ausführungsform der Erfindung weisen die elektrisch leitfähigen Partikel eine bestimmte Oberflächenenergie auf, die gut mit einem Planarisierungsmaterial benetzbar ist.

Gemäß einer Weiterbildung der Erfindung ist vorgesehen, dass die elektrisch leitfähigen Partikel aus leitfähig beschichtetem Glas, bevorzugt mit Silber beschichtet, aus leitfähigem Metall, bevorzugt paus Nickel oder einer Legierung davon, oder aus Kristalliten ausgebildet sind.

Gemäß einer Weiterbildung der Erfindung ist vorgesehen, dass ein Anteil des Volumens der elektrisch leitfähigen Partikel in der Planarisierungsschicht 10 bis 50% beträgt, bevorzugt 20 bis 40%, bevorzugt 10 bis 30%, bevorzugt 10 bis 20%, bevorzugt 5 bis 30%, oder bevorzugt 5 bis 20%, jeweils bezogen auf das Gesamtvolumen der Planarisierungsschicht, und/oder ein Anteil der Oberfläche der elektrisch leitfähigen Partikel auf einer der Barriereschicht zugewandten Seite der Planarisierungsschicht 10 bis 50% beträgt, bevorzugt 10 bis 30%, bevorzugt 10 bis 20%, bevorzugt 5 bis 50%, bevorzugt 5 bis 30%, bevorzugt 5 bis 20%, oder bevorzugt 5 bis 10%, jeweils bezogen auf die Oberfläche der Planarisierungsschicht, und/oder die elektrisch leitfähigen Partikel in der Planarisierungsschicht zumindest weitgehend im Bereich der mindestens einen Stromsammelschiene angeordnet sind.

In einer bevorzugten Ausführungsform der Erfindung sind die elektrisch leitfähigen Partikel in der Planarisierungsschicht zumindest weitgehend im Bereich der mindestens einen folgenden Stromsammelschiene angeordnet. In einer bevorzugten Ausführungsform der Erfindung sind die elektrisch leitfähigen Partikel in der Planarisierungsschicht zumindest weitgehend unter der mindestens einen Stromsammelschiene angeordnet.

In einer bevorzugten Ausführungsform der Erfindung ist das optoelektronische Bauelement ein flexibles optoelektronisches Bauelement, bevorzugt ein flexibles photovoltaisches Element, insbesondere bevorzugt ein flexibles organisches photovoltaisches Element.

Gemäß einer Weiterbildung der Erfindung ist vorgesehen, dass das optoelektronische Bauelement ein organisches photovoltaisches Element ist, bevorzugt ein flexibles organisches photovoltaisches Element, wobei bevorzugt mindestens eine photoaktive Schicht des organischen photovoltaischen Elements kleine Moleküle als Absorbermaterial aufweist.

Unter einem flexiblen optoelektronischen Bauelement wird insbesondere ein optoelektronisches Bauelement verstanden, dass in einem bestimmten Bereich biegbar und/oder dehnbar ist.

In einer bevorzugten Ausführungsform der Erfindung ist das optoelektronische Bauelement mittels mindestens einer weiteren Barriereschicht verkapselt, wobei die mindestens eine Stromsammelschiene aus der mindestens einen weiteren Barriereschicht herausgeführt ist. Vorzugsweise ist die Verkapselung eine Dünnschichtverkapselung.

In einer bevorzugten Ausführungsform der Erfindung weist das optoelektronische Bauelement eine Verkapselung aus mindestens einer Barriereschicht auf, die das optoelektronische Bauelement diffusionsdicht umschließt, also abdichtet. In einer bevorzugten Ausführungsform ist die Verkapselung eine Polymerverkapselung.

In einer bevorzugten Ausführungsform der Erfindung weist das optoelektronische Bauelement mindestens eine erste photovoltaische Zelle und eine zweite photovoltaische Zelle auf, wobei die erste photovoltaische Zelle und die zweite photovoltaische Zelle in Reihe geschaltet sind, und wobei bevorzugt die Deckelektrode der ersten photovoltaischen Zelle mit der Grundelektrode der zweiten photovoltaischen Zelle elektrisch leitend verbunden ist.

Die Aufgabe der vorliegenden Erfindung wird auch gelöst, indem ein Verfahren zur Kontaktierung eines optoelektronischen Bauelements, insbesondere eines flexiblen optoelektronischen Bauelements, bereitgestellt wird, insbesondere nach einem der zuvor beschriebenen Ausführungsbeispiele. Dabei ergeben sich für das Verfahren zur Kontaktierung des optoelektronischen Bauelements insbesondere die Vorteile, die bereits in Zusammenhang mit dem optoelektronischen Bauelement beschrieben wurden. Das Verfahren umfasst dabei die folgenden Schritte:
a) Bereitstellen eines Substrats mit einer darauf angeordneten Grundelektrode, einem Schichtsystem mit mindestens einer photoaktiven Schicht, und einer Deckelektrode, wobei das Schichtsystem zwischen der Grundelektrode und der Deckelektrode angeordnet ist,
b) Aufbringen eines Planarisierungsmaterials auf die Grundelektrode und/oder die Deckelektrode,
c) Einbringen elektrisch leitfähiger Partikel in und/oder auf das Planarisierungsmaterial,
d) Aushärten des Planarisierungsmaterials, bevorzugt durch UV-Strahlung und/oder thermische Behandlung, wobei eine Planarisierungsschicht mit den elektrisch leitfähigen Partikeln gebildet wird,
e) Aufbringen mindestens einer Barriereschicht auf die Planarisierungsschicht, wobei bevorzugt die mindestens eine Barriereschicht zumindest teilweise mit den elektrisch leitfähigen Partikeln durchstoßen wird, und
f) Aufbringen mindestens einer Stromsammelschiene auf die mindestens eine Barriereschicht, so dass die Grundelektrode und/oder die Deckelektrode über die elektrisch leitfähigen Partikel mit der mindestens einen Stromsammelschiene elektrisch leitend kontaktiert werden.

In einer bevorzugten Ausführungsform der Erfindung werden Schritt b) und Schritt c) gleichzeitig durchgeführt, insbesondere sind die elektrisch leitfähigen Partikel zumindest teilweise bereits in dem Planarisierungsmaterial enthalten.

Unter einem Planarisierungsmaterial wird insbesondere ein Material verstanden, welches nach dem Auftragen auf eine Oberfläche durch aushärten, insbesondere vernetzen, eine Planarisierungsschicht ausbildet.

In einer bevorzugten Ausführungsform der Erfindung wird das Planarisierungsmaterial direkt auf die zu ebnende Schicht, insbesondere die Grundelektrode und/oder die Deckelektrode, aufgebracht.

In einer bevorzugten Ausführungsform der Erfindung ist das Planarisierungsmaterial ein Planarisierungslack. In einer bevorzugten Ausführungsform der Erfindung wird das Planarisierungsmaterial in flüssiger Form aufgetragen.

In einer bevorzugten Ausführungsform werden die elektrisch leitfähigen Partikel in Schritt c) mittels eines Tintenstrahldruck-Verfahrens, eines Offset-druck-Verfahrens, eines Plexodruck-Verfahrens, eines Tiefdruck-Verfahrens, eines Siebdruck-Verfahrens oder eines Rakel-Verfahrens in die Planarisierungsschicht eingebracht.

In einer bevorzugten Ausführungsform der Erfindung wird die mindestens eine Barriereschicht in Schritt e) und/oder in Schritt f) von den elektrisch leitfähigen Partikeln zumindest teilweise durchstoßen.

In einer bevorzugten Ausführungsform der Erfindung werden die Schichten mittels eines Druckverfahrens, bevorzugt einem Inkjet-Verfahren, einem Siebdruckverfahren, und/oder einem Flexoprint-Verfahren, und/oder mittels Verdampfung der aufzubringenden Materialen aufgetragen. Diese Verfahren sind dem Fachmann bekannt und werden deshalb an dieser Stelle nicht näher erläutert.

Gemäß einer Weiterbildung der Erfindung ist vorgesehen, dass das Planarisierungsmaterial in Schritt b) mittels einer Nassbeschichtung aufgetragen wird, und/oder die elektrisch leitfähigen Partikel in Schritt c) in bestimmte Bereiche des Planarisierungsmaterials eingebracht werden, bevorzugt in Bereiche des Planarisierungsmaterials mit in Schritt f) folgendem Aufbringen der mindestens einen Stromsammelschiene.

Gemäß einer Weiterbildung der Erfindung ist vorgesehen, dass die elektrisch leitfähigen Partikel in Schritt c) mittels Druck in das Planarisierungsmaterial eingebracht werden, bevorzugt mittels einer Andruckrolle oder im Falle von magnetischen Partikeln mittels eines unter dem zu kontaktierenden optoelektronischen Bauelement angeordneten Magneten.

In einer bevorzugten Ausführungsform der Erfindung wird das Verfahren in einem Rolle-zu-Rolle Verfahren eingesetzt.

In einer bevorzugten Ausführungsform der Erfindung werden die elektrisch leitfähigen Partikel mittels eines Transferbands auf die Barriereschicht aufgebracht. Nach Vernetzung der Planarisierungsschicht haften die eingebrachten Partikel besser in der Planarisierungsschicht als an dem Transferband, so dass das Transferband von der Planarisierungsschicht abgezogen werden kann. Vorzugsweise ist das Transferband zum Auftragen der elektrisch leitfähigen Partikel für UV-Strahlung zumindest teilweise transparent, so dass die Barriereschicht bei aufliegendem Transportband gehärtet werden kann.

In einer bevorzugten Ausführungsform der Erfindung wird die mindestens eine Stromsammelschiene auf die Barriereschicht aufgeprägt, wobei auf der Stromsammelschiene eine bestimmte Topologie ausgebildet wird, die bevorzugt eine Größe von 10 bis 100% der Schichtdicke der Planarisierungsschicht aufweist, bevorzugt 10 bis 70%, bevorzugt 10 bis 50%, oder bevorzugt 10 bis 30%. In einer bevorzugten Ausführungsform der Erfindung wird die mindestens eine Stromsammelschiene nach dem Aufbringen des Planarisierungslacks in diesen aufgelegt und/oder eingedrückt.

Die Erfindung wird im Folgenden anhand der Zeichnungen näher erläutert. Dabei zeigen:
Fig. 1 eine schematische Darstellung eines Aufbaus eines Schichtsystems mit Elektroden eines optoelektronischen Bauelements;
Fig. 2 eine schematische Darstellung eines Ausführungsbeispiels eines optoelektronischen Bauelements mit einer Planarisierungsschicht mit elektrisch leitfähigen Partikeln in einer Seitenansicht.

### Ausführungsbeispiele

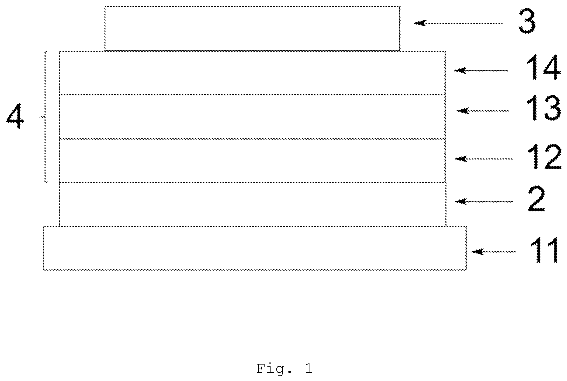

Fig. 1 zeigt eine schematische Darstellung eines Aufbaus eines Schichtsystems 4 mit Elektroden 2,3 eines optoelektronischen Bauelements 1.

Optoelektronische Bauelemente 1, insbesondere organische photovoltaische Elemente, bestehen aus einer Folge dünner Schichten mit mindestens einer photoaktiven Schicht, welche bevorzugt im Vakuum aufgedampft oder aus einer Lösung prozessiert werden. Die elektrische Anbindung, also eine Kontaktierung, kann durch Metallschichten, transparente leitfähige Oxide und/oder transparente leitfähige Polymere erfolgen. Das Vakuum-Aufdampfen der organischen Schichten ist insbesondere vorteilhaft bei der Herstellung von mehrschichtigen Solarzellen, insbesondere Tandem- oder Triple-Zellen. Ein Schichtsystem 4 eines solchen optoelektronischen Bauelements 1 ist in einem Ausführungsbeispiel in Fig. 1 dargestellt.

In diesem Ausführungsbeispiel weist das optoelektronische Bauelement 1 eine auf einem Substrat 11, insbesondere aus Glas, angeordnete Grundelektrode 2, insbesondere eine transparente Grundelektrode aus ITO, auf. Darauf ist das Schichtsystem 4, mit einer n-Schicht 12 mit Fulleren C60 als Ladungsträgerschicht, einer photoaktiven Schicht 13 mit mindestens einem Absorbermaterial und Fulleren C60, und einer p-Schicht 14 als Löchertransportschicht aus Di-NPB und NDP9, ausgebildet. Darauf ist eine Deckelektrode 3, insbesondere aus Gold, angeordnet. Das Schichtsystem 4 und/oder die Elektroden 2,3 werden gewöhnlich laserstrukturiert. Das Schichtsystem 4 kann weitere Lochinjektionsschichten, Lochtransportschichten, photoaktive Schichten, Elektronentransportschichten und/oder Elektroneninjektionsschichten aufweisen.

Die Topographie eines laserstrukturierten optoelektronischen Bauelements 1 weist gewöhnlich Aufwürfe auf (nicht dargestellt), die es gilt für eine folgende Schicht, insbesondere eine Barriereschicht 6, zu planarisieren, insbesondere mittels einer Planarisierungsschicht 5. Die Barriereschicht 6 kann, insbesondere nach einer zuvor aufgetragenen Planarisierungsschicht 5, über der Deckelektrode 3 angeordnet werden. Die Barriereschicht 6 kann insbesondere eine Dünnschichtverkapselung sein.

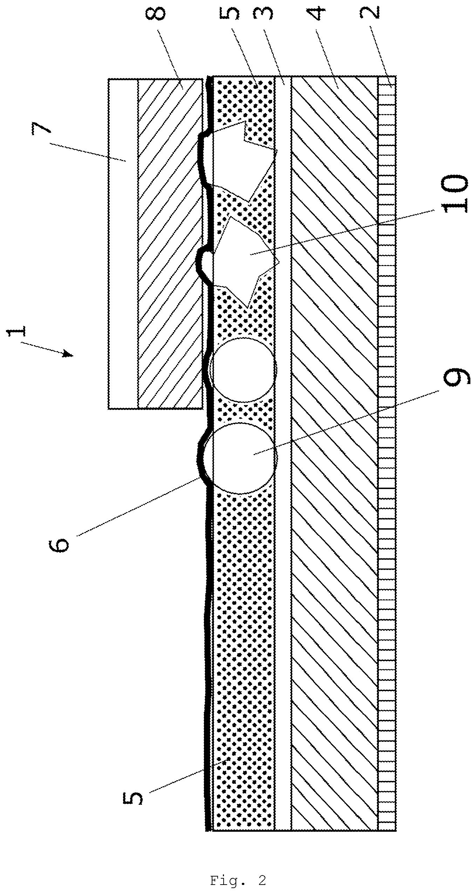

Fig. 2 zeigt eine schematische Darstellung eines Ausführungsbeispiels eines optoelektronischen Bauelements 1 mit einer Planarisierungsschicht 5 mit elektrisch leitfähigen Partikeln 9,10 in einer Seitenansicht. Gleiche und funktionsgleiche Elemente sind mit den gleichen Bezugszeichen versehen, so dass insofern auf die vorangegangene Beschreibung verwiesen wird. Die Größenverhältnisse der Schichten des Schichtsystems 4 sind nicht maßstabsgerecht dargestellt.

Das optoelektronische Bauelement 1, insbesondere ein photovoltaisches Element, weist eine Grundelektrode 2, eine Deckelektrode 3, ein Schichtsystem 4 mit mindestens einer photoaktiven Schicht, wobei das Schichtsystem 4 zwischen der Grundelektrode 2 und der Deckelektrode 3 angeordnet ist, eine auf der von dem Schichtsystem 4 abgewandten Seite der Grundelektrode 2 und/oder der Deckelektrode 3 angeordnete Planarisierungsschicht 5, mindestens eine auf der Planarisierungsschicht 5 angeordnete Barriereschicht 6, und mindestens eine Stromsammelschiene 7 auf, wobei die mindestens eine Stromsammelschiene 7 auf der mindestens einen Barriereschicht 6 angeordnet ist. Die Planarisierungsschicht 5 weist elektrisch leitfähige Partikel 9,10 auf, wobei die elektrisch leitfähigen Partikel 9,10 zumindest weitgehend in die Planarisierungsschicht 5 eingebracht sind, und wobei die elektrisch leitfähigen Partikel 9,10 die Planarisierungsschicht 5 durch die mindestens eine Barriereschicht 6 hindurch elektrisch leitend überbrücken, so dass die Grundelektrode 2 und/oder die Deckelektrode 3 mit der mindestens einen Stromsammelschiene 7 elektrisch leitend kontaktiert sind.

Dadurch wird eine einfache und sichere elektrisch leitende Kontaktierung des optoelektronischen Bauelements 1, insbesondere innerhalb des optoelektronischen Bauelements 1 zwischen einer Elektrode 2,3 und einer Stromsammelschiene 7 gewährleistet. Dadurch wird insbesondere die Planarisierungsschicht 5 durch die elektrisch leitfähigen Partikel 9,10 elektrisch leitend überbrückt. Es werden keine oder kaum Verluste der elektrischen Leitfähigkeit bei einer solchen elektrisch leitenden Kontaktierung beobachtet. Die elektrisch leitfähigen Partikel 9,10 sind besonders leicht in die Planarisierungsschicht 5 integrierbar.

In einer Ausgestaltung der Erfindung weist die Planarisierungsschicht 5 eine Schichtdicke von 5 µm bis 100 µm auf, bevorzugt von 10 µm bis 50 µm, und/oder weist die mindestens eine Barriereschicht 6 eine Schichtdicke von 100 nm bis 2000 nm auf, oder bevorzugt von 200 nm bis 800 nm.

In einer weiteren Ausgestaltung der Erfindung weisen die elektrisch leitfähigen Partikel 9,10 einen mittleren Durchmesser von 1 µm bis 100 µm auf, bevorzugt von 1 µm bis 50 µm, und/oder der mittlere Durchmesser der elektrisch leitfähigen Partikel 9,10 ist größer als die Schichtdicke der Planarisierungsschicht 5, bevorzugt bis zu 100% größer als die Schichtdicke der Planarisierungsschicht 5, oder bevorzugt bis zu 10% größer.

In einer weiteren Ausgestaltung der Erfindung ist die Form der elektrisch leitfähigen Partikel 9,10 kugelförmig, eckig, nadelförmig, und/oder kristallförmig ausgebildet, bevorzugt ist die Form der elektrisch leitfähigen Partikel 9,10 untereinander unterschiedlich ausgebildet, und/oder sind die elektrisch leitfähigen Partikel 9,10 regelmäßig oder unregelmäßig geformt, bevorzugt als Splitter, Kristalle oder Granulat ausgebildet.

In einer weiteren Ausgestaltung der Erfindung sind die elektrisch leitfähigen Partikel 9,10 aus leitfähig beschichtetem Glas, bevorzugt mit Silber beschichtet, aus leitfähigem Metall, bevorzugt aus Nickel oder einer Legierung davon, oder aus Kristalliten ausgebildet.

In einer weiteren Ausgestaltung der Erfindung beträgt ein Anteil des Volumens der elektrisch leitfähigen Partikel 9,10 in der Planarisierungsschicht 5 10 bis 30%, bezogen auf das Gesamtvolumen der Planarisierungsschicht 5, und/oder beträgt ein Anteil der Oberfläche der elektrisch leitfähigen Partikel 9,10 auf einer der Barriereschicht 6 zugewandten Seite der Planarisierungsschicht 5 10 bis 50%, bevorzugt 10 bis 30%, bezogen auf die Oberfläche der Planarisierungsschicht 5, und/oder sind die elektrisch leitfähigen Partikel 9,10 in der Planarisierungsschicht 5 zumindest weitgehend im Bereich der mindestens einen Stromsammelschiene 7 angeordnet.

In einer weiteren Ausgestaltung der Erfindung ist das optoelektronische Bauelement 1 ein organisches photovoltaisches Element, bevorzugt ein flexibles organisches photovoltaisches Element, wobei bevorzugt mindestens eine photoaktive Schicht des organischen photovoltaischen Elements kleine Moleküle als Absorbermaterial aufweist.

Das Verfahren zur Kontaktierung des optoelektronischen Bauelements 1, insbesondere eines flexiblen optoelektronischen Bauelements 1, umfasst die folgenden Schritte:
a) Bereitstellen eines Substrats mit einer darauf angeordneten Grundelektrode 2, einem Schichtsystem 4 mit mindestens einer photoaktiven Schicht, und einer Deckelektrode 3, wobei das Schichtsystem 4 zwischen der Grundelektrode 2 und der Deckelektrode 3 angeordnet ist,
b) Aufbringen eines Planarisierungsmaterials auf die Grundelektrode 2 und/oder die Deckelektrode 3,
c) Einbringen elektrisch leitfähiger Partikel 9,10 in und/oder auf das Planarisierungsmaterial,
d) Aushärten des Planarisierungsmaterials, bevorzugt durch UV-Strahlung und/oder thermische Behandlung, wobei eine Planarisierungsschicht 5 mit den elektrisch leitfähigen Partikeln 9,10 gebildet wird,
e) Aufbringen mindestens einer Barriereschicht 6 auf die Planarisierungsschicht 5, wobei bevorzugt die mindestens eine Barriereschicht 6 zumindest teilweise mit den elektrisch leitfähigen Partikeln 9,10 durchstoßen wird, und
f) Aufbringen mindestens einer Stromsammelschiene 7 auf die mindestens eine Barriereschicht 6, so dass die Grundelektrode 2 und/oder die Deckelektrode 3 mit der mindestens einen Stromsammelschiene 7 elektrisch leitend kontaktiert werden.

In einer weiteren Ausgestaltung der Erfindung wird das Planarisierungsmaterial in Schritt b) mittels einer Nassbeschichtung aufgetragen, und/oder werden die elektrisch leitfähigen Partikel 9,10 in Schritt c) in bestimmte Bereiche des Planarisierungsmaterials eingebracht, bevorzugt in Bereiche des Planarisierungsmaterials mit in Schritt f) folgendem Aufbringen der mindestens einen Stromsammelschiene 7.

In einer weiteren Ausgestaltung der Erfindung werden die elektrisch leitfähigen Partikel 9,10 in Schritt c) mittels Druck in das Planarisierungsmaterial eingebracht, bevorzugt mittels einer Andruckrolle oder im Falle von magnetischen Partikeln mittels eines unter dem zu kontaktierenden optoelektronischen Bauelement 1 angeordneten Magneten.

Vor und/oder während dem Aufbringen der mindestens einen Stromsammelschiene 7 auf die Barriereschicht 6 wird die mindestens eine Barriereschicht 6 zur Kontaktierung durchstoßen, also die Barriereschicht 6 an der Stelle der elektrisch leitfähigen Partikel 9,10 geöffnet. Die Barriereschicht 6 selbst ist nicht leitfähig und bedeckt die aus der Planarisierungsschicht 5 herausragenden elektrisch leitfähigen Partikel 9,10.

Das Verfahren ist insbesondere in ein Rolle-zu-Rolle Verfahren integrierbar.

In einer weiteren Ausgestaltung der Erfindung weist das Schichtsystem 4 mindestens zwei photoaktive Schichten auf, wobei die photovoltaische Zelle eine Tandem-Zelle ist, bevorzugt mindestens drei photoaktive Schichten, wobei die photovoltaische Zelle eine Triple-Zelle ist, und/oder weist das Schichtsystem 4 zusätzlich mindestens eine Ladungsträgertransportschicht auf, wobei die mindestens eine Ladungsträgertransportschicht zwischen der Grundelektrode 2 oder der Deckelektrode 3 und einer photoaktiven Schicht angeordnet ist, bevorzugt mindestens eine erste Ladungsträgertransportschicht und eine zweite Ladungsträgertransportschicht, wobei die erste Ladungsträgertransportschicht zwischen der Grundelektrode 2 und der mindestens einen photoaktiven Schicht angeordnet ist, und wobei die zweite Ladungsträgertransportschicht zwischen der mindestens einen photoaktiven Schicht und der Deckelektrode 3 angeordnet ist.

Die schematische Schichtfolge eines Kontaktierungsaufbaus eines optoelektronischen Bauelements 1 in einem Ausführungsbeispiel (Fig. 2) ist folgendermaßen ausgebildet: Auf dem Schichtsystem 4, das auf der Grundelektrode 2 angeordnet ist, befindet sich eine Deckelektrode 3. Auf der Deckelektrode 3 ist die Planarisierungsschicht 5 angeordnet, die elektrisch leitfähige Partikel 9,10 aufweist, wobei die Planarisierungsschicht 5 eine Schichtdicke von 50 µm aufweist und ein mittlerer Durchmesser der elektrisch leitfähigen Partikel 9,10 größer ist als die Schichtdicke der Planarisierungsschicht 5, in diesem Ausführungsbeispiel größer als 50 µm. Die elektrisch leitfähigen Partikel 9,10 können regelmäßig geformt sein 9 oder unregelmäßig geformt sein 10. Die elektrisch leitfähigen Partikel 9,10 sind beispielsweise aus mit leitfähigem Silber beschichteten Glaspartikeln oder aus leitfähigen Metallpartikeln, insbesondere aus Nickel oder einer Legierung davon, gebildet. Auf der Planarisierungsschicht 5 mit den elektrisch leitfähigen Partikeln 9,10 ist die Barriereschicht 6 angeordnet, die eine Schichtdicke von weniger al 1 µm aufweist. Die Barriereschicht 6 ist über die Planarisierungsschicht 5 mit den eingebetteten elektrisch leitfähigen Partikeln 9,10 hinweg abgeschieden. In dem vorliegenden Ausführungsbeispiel weist die Barriereschicht 6 eine Schichtdicke von weniger als 1 µm auf. Die Barriereschicht 6 ist zumindest teilweise von den elektrisch leitfähigen Partikeln 9,10 durchstoßen, so dass eine elektrisch leitende Verbindung durch die Barriereschicht 6 hindurch gebildet ist. Auf der Barrierschicht 6 ist eine Stromsammelschiene 7 und eine daran angeordnete Klebeschicht 8 angeordnet. Die elektrisch leitende Kontaktierung zwischen der Deckelektrode 3 und der mindestens einen Stromsammelschiene 7 ist also insbesondere mittels der elektrisch leitfähigen Partikel 9,10 gebildet. In dem vorliegenden Ausführungsbeispiel weist die Stromsammelschiene 7 mit der daran angeordneten Klebeschicht 8 eine Schichtdicke von 35 µm auf.

Das in Schritt a) bereitgestellte Substrat 11 mit der Grundelektrode 2, dem auf der Grundelektrode 2 angeordneten Schichtsystem 4, und der Deckelektrode 3 kann in einer Ausführungsform folgendermaßen erhalten werden: Nach der Bereitstellung des Substrats 11 wird auf diesem die Grundelektrode 2 des photovoltaischen Elements aufgebracht und strukturiert. Anschließend wird das Schichtsystem 4 auf die Grundelektrode 2 aufgebracht. Das Schichtsystem 4 kann als Single-, Tandem- oder Mehrfachzelle aufgebracht werden, bevorzugt durch Verdampfen von kleinen Molekülen. Anschließend erfolgt die Strukturierung des Schichtsystems 4, worauf das Aufbringen der Deckelektrode 3 und die abschließende Strukturierung erfolgt. Das Aufbringen der Schichten auf einen Bereich des Grundkontakts 3 zum Bilden des Schichtsystems 4 kann zumindest teilweise durch einen Druckprozess, bevorzugt durch einen Injket-, Siebdruck-, Gravuredruck- oder Flexoprintprozess, oder durch Verdampfung der aufzubringenden Materialien, erfolgen. Die Strukturierung der einzelnen Schichten kann beispielsweise mittels Laserablation, Elektronen- oder Ionenstrahlablation, oder Schattenmasken erfolgen.

## Patentansprüche

1. Optoelektronisches Bauelement (1), insbesondere photovoltaisches Element, aufweisend eine Grundelektrode (2), eine Deckelektrode (3), und ein Schichtsystem (4) mit mindestens einer photoaktiven Schicht, wobei das Schichtsystem (4) zwischen der Grundelektrode (2) und der Deckelektrode (3) angeordnet ist, eine auf der von dem Schichtsystem (4) abgewandten Seite der Grundelektrode (2) und/oder der Deckelektrode (3) angeordnete Planarisierungsschicht (5), mindestens eine auf der Planarisierungsschicht (5) angeordnete Barriereschicht (6), wobei die Barriereschicht nicht elektrisch leitfähig ist und über das gesamte Schichtsystem des optoelektronischen Bauelements ausgebildet ist, und mindestens eine Stromsammelschiene (7), wobei die mindestens eine Stromsammelschiene (7) auf der mindestens einen Barriereschicht (6) angeordnet ist, wobei die Planarisierungsschicht (5) elektrisch leitfähige Partikel (9,10) aufweist, wobei die elektrisch leitfähigen Partikel (9,10) in die Planarisierungsschicht (5) eingebracht sind, und wobei die elektrisch leitfähigen Partikel (9,10) die Planarisierungsschicht (5) durch die mindestens eine Barriereschicht (6) hindurch elektrisch leitend überbrücken, so dass die Grundelektrode (2) und/oder die Deckelektrode (3) mit der mindestens einen Stromsammelschiene (7) elektrisch leitend kontaktiert sind.

2. Optoelektronisches Bauelement (1) nach Anspruch 1, **dadurch gekennzeichnet, dass** die Planarisierungsschicht (5) eine Schichtdicke von 5 µm bis 100 µm aufweist, bevorzugt von 10 µm bis 50 µm, und/oder die mindestens eine Barriereschicht (6) eine Schichtdicke von 100 nm bis 2000 nm aufweist, bevorzugt von 200 nm bis 800 nm.

3. Optoelektronisches Bauelement (1) nach Anspruch 1 oder 2, **dadurch gekennzeichnet, dass** die elektrisch leitfähigen Partikel (9,10) einen mittleren Durchmesser von 1 µm bis 100 µm aufweisen, bevorzugt von 1 µm bis 50 µm, und/oder der mittlere Durchmesser der elektrisch leitfähigen Partikel (9,10) größer ist als die Schichtdicke der Planarisierungsschicht (5), bevorzugt bis zu 100% größer als die Schichtdicke der Planarisierungsschicht (5), oder bevorzugt bis zu 10% größer.

4. Optoelektronisches Bauelement (1) nach einem der vorhergehenden Ansprüche, **dadurch gekennzeichnet, dass** die Form der elektrisch leitfähigen Partikel (9,10) kugelförmig, eckig, nadelförmig, und/oder kristallförmig ausgebildet ist, bevorzugt ist die Form der elektrisch leitfähigen Partikel (9,10) untereinander unterschiedlich ausgebildet, und/oder die elektrisch leitfähigen Partikel (9,10) regelmäßig oder unregelmäßig geformt sind, bevorzugt als Splitter, Kristalle oder Granulat ausgebildet sind.

5. Optoelektronisches Bauelement (1) nach einem der vorhergehenden Ansprüche, **dadurch gekennzeichnet, dass** die elektrisch leitfähigen Partikel (9,10) aus leitfähig beschichtetem Glas, bevorzugt mit Silber beschichtet, aus leitfähigem Metall, bevorzugt aus Nickel oder einer Legierung davon, oder aus Kristalliten ausgebildet sind.

6. Optoelektronisches Bauelement (1) nach einem der vorhergehenden Ansprüche, **dadurch gekennzeichnet, dass** ein Anteil des Volumens der elektrisch leitfähigen Partikel (9,10) in der Planarisierungsschicht (5) 10 bis 30% beträgt, bezogen auf das Gesamtvolumen der Planarisierungsschicht (5), und/oder ein Anteil der Oberfläche der elektrisch leitfähigen Partikel (9,10) auf einer der Barriereschicht (6) zugewandten Seite der Planarisierungsschicht (5) 10 bis 50% beträgt, bevorzugt 10 bis 30%, bezogen auf die Oberfläche der Planarisierungsschicht (5), und/oder die elektrisch leitfähigen Partikel (9,10) in der Planarisierungsschicht (5) im Bereich der mindestens einen Stromsammelschiene (7) angeordnet sind.

7. Optoelektronisches Bauelement (1) nach einem der vorhergehenden Ansprüche, **dadurch gekennzeichnet, dass** das optoelektronische Bauelement (1) ein organisches photovoltaisches Element ist, bevorzugt ein flexibles organisches photovoltaisches Element, wobei bevorzugt mindestens eine photoaktive Schicht des organischen photovoltaischen Elements kleine Moleküle als Absorbermaterial aufweist.

8. Verfahren zur Kontaktierung eines optoelektronischen Bauelements (1) nach einem der Ansprüche 1 bis 7, insbesondere eines flexiblen optoelektronischen Bauelements (1), umfassend die folgenden Schritte:
a) Bereitstellen eines Substrats mit einer darauf angeordneten Grundelektrode (2), einem Schichtsystem (4) mit mindestens einer photoaktiven Schicht, und einer Deckelektrode (3), wobei das Schichtsystem (4) zwischen der Grundelektrode (2) und der Deckelektrode (3) angeordnet ist,
b) Aufbringen eines Planarisierungsmaterials auf die Grundelektrode (2) und/oder die Deckelektrode (3),
c) Einbringen elektrisch leitfähiger Partikel (9,10) in und/oder auf das Planarisierungsmaterial,
d) Aushärten des Planarisierungsmaterials, bevorzugt durch UV-Strahlung und/oder thermische Behandlung, wobei eine Planarisierungsschicht (5) mit den elektrisch leitfähigen Partikeln (9,10) gebildet wird,
e) Aufbringen mindestens einer nicht elektrisch leitfähigen Barriereschicht (6) auf die Planarisierungsschicht (5) über das gesamte Schichtsystem des optoelektronischen Bauelements, wobei bevorzugt die mindestens eine Barriereschicht (6) zumindest teilweise mit den elektrisch leitfähigen Partikeln (9,10) durchstoßen wird, und
f) Aufbringen mindestens einer Stromsammelschiene (7) auf die mindestens eine Barriereschicht (6), so dass die Grundelektrode (2) und/oder die Deckelektrode (3) über die elektrisch leitfähigen Partikel (9,10) mit der mindestens einen Stromsammelschiene (7) elektrisch leitend kontaktiert werden.

9. Verfahren zur Kontaktierung eines optoelektronischen Bauelements (1) nach Anspruch 8, wobei das Planarisierungsmaterial in Schritt b) mittels einer Nassbeschichtung aufgetragen wird, und/oder die elektrisch leitfähigen Partikel (9,10) in Schritt c) in bestimmte Bereiche des Planarisierungsmaterials eingebracht werden, bevorzugt in Bereiche des Planarisierungsmaterials mit in Schritt f) folgendem Aufbringen der mindestens einen Stromsammelschiene (7).

10. Verfahren zur Kontaktierung eines optoelektronischen Bauelements (1) nach Anspruch 8 oder 9, wobei die elektrisch leitfähigen Partikel (9,10) in Schritt c) mittels Druck in das Planarisierungsmaterial eingebracht werden, bevorzugt mittels einer Andruckrolle oder im Falle von magnetischen Partikeln mittels eines unter dem zu kontaktierenden optoelektronischen Bauelement (1) angeordneten Magneten.

## Claims

1. Optoelectronic component (1), in particular photovoltaic element, comprising a base electrode (2), a top electrode (3) and a layer system (4) having at least one photoactive layer, the layer system (4) being disposed between the base electrode (2) and the top electrode (3), a planarization layer (5) arranged on the side of the base electrode (2) and/or top electrode (3) facing away from the layer system (4), at least one barrier layer (6) arranged on the planarization layer (5), wherein the barrier layer is not electrically conductive and formed over the entire layer system of the optoelectronic component, and at least one busbar (7), wherein the at least one busbar (7) is arranged on the at least one barrier layer (6), wherein the planarization layer (5) has electrically conductive particles (9, 10), wherein the electrically conductive particles (9, 10) being introduced into the planarization layer (5), and wherein the electrically conductive particles (9, 10) are electrically conductively bridging the planarization layer (5) through the at least one barrier layer (6) such that the base electrode (2) and/or the top electrode (3) are electrically conductively contacted with the at least one busbar (7).

2. Optoelectronic component (1) according to Claim 1, wherein the planarization layer (5) has a layer thickness from 5 µm to 100 µm, preferably from 10 µm to 50 µm, and/or the at least one barrier layer (6) has a layer thickness from 100 nm to 2000 nm, preferably from 200 nm to 800 nm.

3. Optoelectronic component (1) according to Claim 1 or 2, wherein the electrically conductive particles (9, 10) have a mean diameter from 1 µm to 100 µm, preferably from 1 µm to 50 µm, and/or the mean diameter of the electrically conductive particles (9, 10) is greater than the layer thickness of the planarization layer (5), preferably up to 100% greater than the layer thickness of the planarization layer (5), or preferably up to 10% greater.

4. Optoelectronic component (1) according to any of the preceding claims, wherein the shape of the electrically conductive particles (9, 10) is spherical, angular, acicular and/or crystalline, preferably the electrically conductive particles (9, 10) have different shapes, and/or the electrically conductive particles (9, 10) are shaped regularly or irregularly, preferably as splinters, crystals or granulate.

5. Optoelectronic component (1) according to any of the preceding claims, wherein the electrically conductive particles (9, 10) are formed from conductively coated glass, preferably silver-coated glass, from conductive metal, preferably from nickel or an alloy thereof, or from crystallites.

6. Optoelectronic component (1) according to any of the preceding claims, wherein a proportion of the volume of the electrically conductive particles (9, 10) in the planarization layer (5) is 10 to 30%, in relation to the overall volume of the planarization layer (5), and/or a proportion of the surface of the electrically conductive particles (9, 10) on a side of the planarization layer (5) facing the barrier layer (6) is 10 to 50%, preferably 10 to 30%, in relation to the surface of the planarization layer (5), and/or the electrically conductive particles (9, 10) in the planarization layer (5) are disposed in the region of the at least one busbar (7).

7. Optoelectronic component (1) according to any of the preceding claims, wherein the optoelectronic component (1) is an organic photovoltaic element, preferably a flexible organic photovoltaic element, preferably with at least one photoactive layer of the organic photovoltaic element having small molecules as absorber material.

8. Method for contacting an optoelectronic component (1) according to any of Claims 1 to 7, in particular a flexible optoelectronic component (1), comprising the following steps:
a) providing a substrate with a base electrode (2) arranged thereon, a layer system (4) having at least one photoactive layer, and a top electrode (3), wherein the layer system (4) being disposed between the base electrode (2) and the top electrode (3),
b) applying a planarization material on the base electrode (2) and/or the top electrode (3),
c) introducing electrically conductive particles (9, 10) into and/or onto the planarization material,
d) curing the planarization material, preferably by way of UV radiation and/or a thermal treatment, wherein a planarization layer (5) with the electrically conductive particles (9, 10) is formed,
e) applying at least one not electrically conductive barrier layer (6) on the planarization layer (5) over the entire layer system of the optoelectronic component, wherein preferably the at least one barrier layer (6) being at least partly penetrated by the electrically conductive particles (9, 10), and
f) applying at least one busbar (7) on the at least one barrier layer (6) such that the base electrode (2) and/or the top electrode (3) are electrically conductively contacted with the at least one busbar (7) by way of the electrically conductive particles (9, 10).

9. Method for contacting an optoelectronic component (1) according to Claim 8, wherein the planarization material in step b) is applied by means of a wet coating, and/or the electrically conductive particles (9, 10) are introduced into certain regions of the planarization material in step c), preferably in regions of the planarization material with a subsequent application of the at least one busbar (7) in step f).

10. Method for contacting an optoelectronic component (1) according to Claim 8 or 9, wherein the electrically conductive particles (9, 10) are introduced into the planarization material by means of pressure in step c), preferably by means of a pressure roller or, in the case of magnetic particles, by means of a magnet disposed under the optoelectronic component (1) to be contacted.

## Revendications

1. Composant optoélectronique (1), notamment élément photovoltaïque, présentant une électrode de base (2), une électrode de couverture (3), et un système de couches (4) avec au moins une couche photoactive, le système de couches (4) étant agencé entre l'électrode de base (2) et l'électrode de couverture (3), une couche de planarisation (5) agencée sur le côté de l'électrode de base (2) et/ou de l'électrode de couverture (3) détourné du système de couches (4), au moins une couche de barrière (6) agencée sur la couche de planarisation (5), la couche de barrière n'étant pas électriquement conductrice et étant réalisée sur l'ensemble du système de couches du composant optoélectronique, et au moins une barre omnibus (7), l'au moins une barre collectrice de courant (7) étant agencée sur l'au moins une couche de barrière (6), la couche de planarisation (5) présentant des particules électriquement conductrices (9, 10), les particules électriquement conductrices (9, 10) étant introduites dans la couche de planarisation (5), et les particules électriquement conductrices (9, 10) pontant de manière électriquement conductrice la couche de planarisation (5) à travers l'au moins une couche de barrière (6), de telle sorte que l'électrode de base (2) et/ou l'électrode de couverture (3) sont en contact électriquement conducteur avec l'au moins une barre omnibus (7).

2. Composant optoélectronique (1) selon la revendication 1, **caractérisé en ce que** la couche de planarisation (5) présente une épaisseur de couche de 5 µm à 100 µm, de préférence de 10 µm à 50 µm, et/ou l'au moins une couche de barrière (6) présente une épaisseur de couche de 100 nm à 2000 nm, de préférence de 200 nm à 800 nm**.**

3. Composant optoélectronique (1) selon la revendication 1 ou 2, **caractérisé en ce que** les particules électriquement conductrices (9, 10) présentent un diamètre moyen de 1 µm à 100 µm, de préférence de 1 µm à 50 µm, et/ou le diamètre moyen des particules électriquement conductrices (9, 10) est supérieur à l'épaisseur de couche de la couche de planarisation (5), de préférence jusqu'à 100 % supérieur à l'épaisseur de couche de la couche de planarisation (5), ou de préférence jusqu'à 10 % supérieur.

4. Composant optoélectronique (1) selon l'une quelconque des revendications précédentes, **caractérisé en ce que** la forme des particules électriquement conductrices (9, 10) est réalisée sous forme sphérique, angulaire, sous forme d'aiguille et/ou sous forme de cristal, de préférence la forme des particules électriquement conductrices (9, 10) est réalisée de manière différente entre elles, et/ou les particules électriquement conductrices (9, 10) sont formées de manière régulière ou de manière irrégulière, de préférence sous forme d'éclats, de cristaux ou de granulés.

5. Composant optoélectronique (1) selon l'une quelconque des revendications précédentes, **caractérisé en ce que** les particules électriquement conductrices (9, 10) sont réalisées à partir de verre revêtu de manière conductrice, de préférence revêtu d'argent, à partir de métal conducteur, de préférence à partir de nickel ou d'un alliage de celui-ci, ou à partir de cristallites.

6. Composant optoélectronique (1) selon l'une quelconque des revendications précédentes, **caractérisé en ce qu'**une proportion du volume des particules électriquement conductrices (9, 10) dans la couche de planarisation (5) est de 10 à 30 %, par rapport au volume total de la couche de planarisation (5), et/ou une proportion de la surface des particules électriquement conductrices (9,10) sur un côté de la couche de planarisation (5) tourné vers la couche de barrière (6) est de 10 à 50 %, de préférence de 10 à 30 %, par rapport à la surface de la couche de planarisation (5), et/ou les particules électriquement conductrices (9, 10) sont agencées dans la couche de planarisation (5) dans la zone de l'au moins une barre omnibus (7).

7. Composant optoélectronique (1) selon l'une quelconque des revendications précédentes, **caractérisé en ce que** le composant optoélectronique (1) est un élément photovoltaïque organique, de préférence un élément photovoltaïque organique flexible, de préférence au moins une couche photoactive de l'élément photovoltaïque organique présentant des petites molécules en tant que matériau absorbant.

8. Procédé de mise en contact d'un composant optoélectronique (1) selon l'une quelconque des revendications 1 à 7, notamment d'un composant optoélectronique flexible (1), comprenant les étapes suivantes :
a) la fourniture d'un substrat avec une électrode de base (2) agencée sur celui-ci, un système de couches (4) avec au moins une couche photoactive, et une électrode de couverture (3), le système de couches (4) étant agencé entre l'électrode de base (2) et l'électrode de couverture (3),
b) l'application d'un matériau de planarisation sur l'électrode de base (2) et/ou l'électrode de couverture (3),
c) l'introduction de particules électriquement conductrices (9, 10) dans et/ou sur le matériau de planarisation,
d) le durcissement du matériau de planarisation, de préférence par rayonnement UV et/ou traitement thermique, une couche de planarisation (5) étant formée avec les particules électriquement conductrices (9, 10),
e) l'application d'au moins une couche de barrière (6) non électriquement conductrice sur la couche de planarisation (5) sur l'ensemble du système de couches du composant optoélectronique, de préférence l'au moins une couche de barrière (6) étant traversée au moins partiellement par les particules électriquement conductrices (9, 10), et
f) l'application d'au moins une barre omnibus (7) sur l'au moins une couche de barrière (6), de telle sorte que l'électrode de base (2) et/ou l'électrode de couverture (3) sont mises en contact électriquement conducteur avec l'au moins une barre omnibus (7) par l'intermédiaire des particules électriquement conductrices (9, 10).

9. Procédé de mise en contact d'un composant optoélectronique (1) selon la revendication 8, dans lequel le matériau de planarisation est appliqué à l'étape b) au moyen d'un revêtement humide, et/ou les particules électriquement conductrices (9, 10) sont introduites à l'étape c) dans des zones déterminées du matériau de planarisation, de préférence dans des zones du matériau de planarisation avec application de l'au moins une barre omnibus (7) à l'étape f).

10. Procédé de mise en contact d'un composant optoélectronique (1) selon la revendication 8 ou 9, dans lequel les particules électriquement conductrices (9, 10) sont introduites dans le matériau de planarisation à l'étape c) au moyen d'une pression, de préférence au moyen d'un rouleau de pression ou, dans le cas de particules magnétiques, au moyen d'un aimant agencé sous le composant optoélectronique (1) à mettre en contact.
